# FASCICULE DE BREVET EUROPEEN

(11) **EP 2 538 438 B1**
(45) Date de publication et mention de la délivrance du brevet: **20.04.2022**
(21) Numéro de dépôt: 12173176.4
(22) Date de dépôt: 22.06.2012
(51) Int. Cl.: H01L 21/762

(54) **Procédé de fabrication d'une structure semi-conductrice mettant en oeuvre un collage temporaire**
Verfahren zur Herstellung einer Halbleiteranordnung mit temporären Verkleben
Method for fabricating a semiconductor structure with temporary bonding

(30) Priorité: 23.06.2011 FR 1155548
(43) Date de publication de la demande: 26.12.2012
(73) Titulaire: Soitec, 38190 Bernin (FR)
(72) Inventeur: Landru, Didier, 38190 CHAMP PRES FROGES (FR); Letertre, Fabrice, 38000 GRENOBLE (FR)
(74) Mandataire: Regimbeau

(56) Documents cités:
- FR-A1- 2 849 715
- FR-A1- 2 855 909
- FR-A1- 2 944 914
- US-A1- 2004 219 762
- GHICA CORNELIU ET AL: "Laser treatment of plasma-hydrogenated silicon wafers for thin layer exfoliation", JOURNAL OF APPLIED PHYSICS, AMERICAN INSTITUTE OF PHYSICS, US, vol. 109, no. 6, 22 March 2011 (2011-03-22), pages 63518-63518, XP012147748, ISSN: 0021-8979, DOI: 10.1063/1.3560538

## Description

### DOMAINE TECHNIQUE GENERAL

La présente invention est relative à la réalisation de structures semi-conductrice pour l'électronique, l'optique ou la microélectronique.

Plus précisément, l'invention concerne un procédé de fabrication d'une structure semi-conductrice avec un collage temporaire d'un substrat sur un autre.

### ETAT DE LA TECHNIQUE

Au cours d'un procédé de fabrication d'une structure semi-conductrice, des transferts de couches comportant, par exemple des circuits intégrés, peuvent être mis en œuvre. De tels transferts permettent notamment de reporter des circuits sur des substrats différents de ceux qui ont servi à les élaborer, ou encore à empiler des circuits pour former des composant « 3D ».

Si la couche mince à transférer est d'épaisseur fine (c'est-à-dire inférieure à 200µm) elle peut, lors du transfert, être susceptible de se fissurer, de se fracturer ou plus généralement d'être endommagée.

Une solution connue, du document EP 0 786 801, pour renforcer la couche à transférer ou le substrat à traiter consiste à coller de manière temporaire un substrat poignée sur le substrat comportant la couche à transférer. La couche à transférer ou le substrat à traiter peut ainsi être librement manipulée et subir toutes les étapes de fabrication nécessaires à son transfert ou traitement.

Dans le document EP 0 786 801 le substrat poignée comprend une zone de clivage qui permet à l'issu du procédé de retirer le substrat poignée le long de cette zone de clivage.

Un problème est qu'un tel substrat poignée consomme du matériau. En outre, il n'est pas évident de recycler la partie restante pour la réutiliser. Il faut en effet mettre en œuvre un polissage ce qui augmente la durée et le coût du procédé.

Une autre solution connue qui ne consomme pas de matériau est de coller de manière temporaire au moyen d'un matériau adhésif le substrat poignée sur le substrat comportant la couche à transférer.

Dans ce cas, le matériau adhésif supporte la force associée au maintien de la couche à transférer et du substrat poignée l'un sur l'autre durant le transfert ou le traitement.

Une fois le transfert ou le traitement effectué, le substrat poignée peut être retiré.

Un problème vient de l'utilisation d'un matériau adhésif.

En effet, les matériaux adhésifs peuvent devenir instables si exposés aux fortes températures impliquées lors des traitements effectués sur le substrat ou lors de la fabrication de structures semi-conductrices mettant en œuvre un transfert.

Par ailleurs, une couche adhésive ne permet pas de maintenir le substrat de manière suffisamment stable pour y opérer certain traitement. C'est le cas lorsque le substrat par exemple est aminci au-delà d'une épaisseur seuil de par exemple 200, 50 ou 40 microns par meulage. Les efforts mécaniques exercés lors de cette étape conduisent à déformer la couche reposant sur la couche adhésive insuffisamment rigide, ce qui à son tour conduit à un amincissement inhomogène du substrat.

En outre, une fois le traitement effectué, le matériau adhésif est complètement éliminé au moyen d'une technique d'élimination chimique (dissolution dans un solvant, par exemple). Une telle élimination augmente la durée du procédé de fabrication et risque d'endommager la structure semi-conductrice obtenue.

Le document US 2004/219762 A1 divulgue l'utilisation d'un substrat poignée comprenant une couche sacrificielle en silicium amorphe pour manipuler un substrat de dispositifs semi-conducteurs.

### PRESENTATION DE L'INVENTION

L'invention permet de pallier les inconvénients ci-dessus mentionnés.

Ainsi, selon un premier aspect de l'invention est un procédé de fabrication d'une structure défini par l'objet de la revendication 1. Le procédé comprend les étapes suivantes :
- fournir un substrat poignée comprenant un substrat de départ et une couche sacrificielle fragilisée recouvrant le substrat de départ ;
- assemblage du substrat poignée avec un substrat à manipuler ;
- traitement éventuel du substrat à manipuler ;
- détachement du substrat poignée au niveau de la couche sacrificielle pour former la structure semi-conductrice ;
- retrait des résidus de la couche sacrificielle présent sur le substrat de départ.

Grâce au procédé de l'invention d'une part le matériau du substrat de départ du substrat poignée peut être choisi parmi une vaste gamme de matériaux. La partie restante de ce substrat est recyclée de manière particulièrement simple pour être à nouveau utilisée de la même manière.

En effet, le recyclage de la partie restante du substrat poignée après l'étape de détachement est réalisé simplement par une simple gravure sélective de la couche sacrificielle, qui suffit à recycler le substrat poignée.

Ce type de procédé de recyclage est bien moins onéreux qu'un recyclage à base de polissage, comme cela est nécessaire à l'issu du procédé décrit dans le document EP 0 786 801 par exemple.

Un autre avantage de l'invention est que le recyclage ne consomme pas d'épaisseur de matériau dans du substrat poignée. Ce substrat poignée étant recouvert d'une couche sacrificielle, c'est cette couche uniquement qui est consommée lors du recyclage. Le substrat poignée est donc théoriquement utilisable à l'infini. Il est ainsi possible de réaliser des économies par rapport aux procédés connus qui impliquent le transfert d'une partie d'un substrat poignée de silicium et son recyclage, en consommant une partie de l'épaisseur de ce substrat.

D'autres aspects du procédé selon le premier aspect de l'invention sont les suivants :
- la fragilisation de la couche sacrificielle est obtenue par introduction d'espèces atomiques dans la couche sacrificielle du substrat poignée ;
- le substrat de départ présente un coefficient de dilatation CTE1 thermique proche du coefficient de dilatation thermique CTE2 du substrat à manipuler tel que |CTE1-CTE2|/CTE1<50% ;
- le substrat poignée comporte une couche intermédiaire disposée entre le substrat de départ et la couche sacrificielle pour favoriser l'adhésion du matériau constituant la couche sacrificielle au substrat de départ ;
- la couche sacrificielle présente une zone de fragilisation et définit une couche située entre la surface du substrat poignée et la zone de fragilisation ;
- avant l'étape de détachement, le procédé comprend une étape consistant à assembler le substrat à manipuler à un substrat receveur ;
- le substrat de départ est choisi de manière à présenter un coefficient de dilatation CTE1 thermique proche du coefficient de dilatation thermique CTE2 du substrat receveur ;
- le substrat à manipuler comporte une partie d'un circuit intégré.
- l'étape de détachement consiste en un apport d'énergie par recuit à une température d'au moins 200°C ;
- l'introduction d'espèces atomiques consiste à exposer une surface du substrat poignée à une implantation d'espèces atomiques, à une dose comprise entre 10¹⁵ ions/cm² et 10¹⁷ ions/cm² et à une énergie comprise entre 5 KeV et 500 KeV ;
- l'introduction d'espèces atomiques consiste en une diffusion d'espèces atomiques dans le substrat poignée consistant à une mise en contact de la surface du substrat poignée avec une espèce chimique qui va pénétrer à l'intérieur par diffusion chimique ;
- l'introduction d'espèces atomiques implique :
   o avant l'introduction d'espèces, la création d'une couche de confinement dans le substrat poignée
   o après l'introduction d'espèces, l'exposition du substrat poignée à une température d'au moins 200°C en vue de favoriser la migration des espèces introduites vers la couche de confinement.
- l'assemblage consiste à coller le substrat poignée sur le substrat à manipuler ;
- l'assemblage est réalisé par adhésion moléculaire ;
- la couche sacrificielle est une couche de polysilicium ;
- le substrat départ est: un substrat cristallin ; ou un substrat amorphe ou partiellement cristallin ; ou une céramique ; ou un métal.

Un second aspect qui ne fait pas partie de l'invention concerne un substrat poignée coprenant un substrat de départ et une couche sacrificielle fragilisée.

D'autres aspects du substrat poignée selon le second aspect sont les suivants :
- la couche sacrificielle contient une densité comprise entre 10^¹⁶ at/cm³ et 10^²⁰ at/cm³ d'H et/ou d'He ;
- la couche sacrificielle est en polysilicium ;
- le substrat de départ est un substrat cristallin, un substrat amorphe ou partiellement cristallin, une céramique ou un métal ;
- il présente une rugosité de surface est de 10 Angstroms RMS ou moins ;
- il présente en surface une couche additionnelle facilitant ultérieurement l'assemblage du substrat poignée avec le substrat à manipuler ;
- la couche additionnelle est en oxyde de silicium.

### PRESENTATION DES FIGURES

D'autres caractéristiques et avantages de l'invention ressortiront encore de la description qui suit laquelle est purement illustrative et non limitative et doit être lue en regard des dessins annexés sur lesquels :
- la figure 1 illustre des étapes d'un procédé conforme à un mode de réalisation de l'invention ;
- les figures 2 à 12 illustrent des configurations rencontrées dans un procédé conforme à un mode de réalisation de l'invention.

Sur l'ensemble des figures, les éléments similaires portent des références numériques identiques.

### DESCRIPTION DETAILLEE DE L'INVENTION

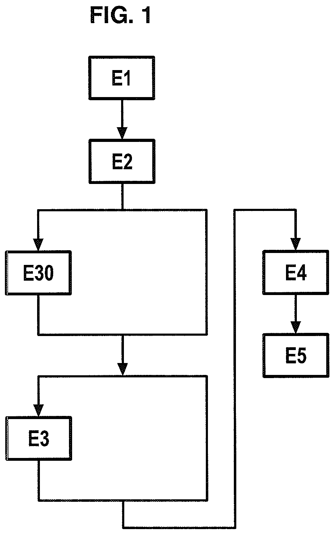

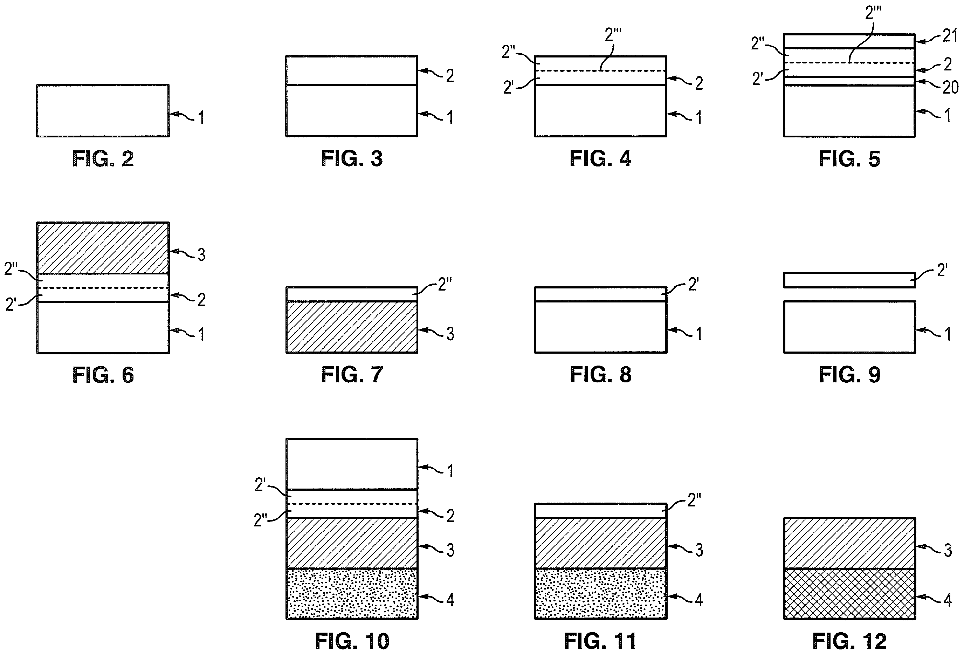

La description qui suit est effectuée en relation avec les figures 1 à 12 qui illustrent un déroulement d'un procédé de fabrication d'une structure semi-conductrice mettant en œuvre un substrat poignée pour supporter un substrat à manipuler.

On entend par structure semi-conductrice n'importe quelle structure qui est utilisée dans la réalisation d'un dispositif à semi-conducteurs. Une structure semi-conductrice peut comprendre des matériaux conducteurs, semi-conducteurs et/ou des matériaux non conducteurs. Il peut s'agir d'une couche comportant ou non des microcomposants ou de microcomposant finis ou semi finis en tant que tels.

On entend par substrat poignée une structure composite dont la fonction est celle de support mécanique temporaire d'un substrat ou d'une structure.

On entend par substrat à manipuler un substrat qui sera assemblé - en particulier temporairement - à un substrat poignée et sur lequel des traitements peuvent être effectués. Il peut s'agir par exemple d'un substrat comportant des microcomposants finis ou semi finis à transférer sur un substrat receveur.

On entend par substrat receveur un substrat destiné à recevoir (typiquement par transfert) un substrat ou une structure.

On entend par couche d'arrêt la première couche qui n'est pas éliminée au cours d'un recyclage.

Au cours d'un procédé de fabrication d'une structure semi-conductrice, dans une première étape E1, on dispose d'un substrat poignée 1, 2 comprenant un substrat de départ 1 et une couche 2 sacrificielle recouvrant le substrat 1 de départ.

La couche 2 sacrificielle est fragilisée ou a été fragilisée préalablement de sorte qu'au cours d'un procédé de fabrication on peut soit disposer du substrat poignée avec la couche 2 sacrificielle préalablement fragilisée soit fragiliser la couche 2 sacrificielle au cours du procédé de fabrication.

La fragilisation de la couche 2 sacrificielle est réalisée par introduction d'espèces atomiques dans la couche 2 sacrificielle. La couche 2 sacrificielle est en polysilicium, car le détachement dans ce matériau est particulièrement aisé. A ce titre, on pourra se référer au document C. H. Yun, N. Quitoriano, N.W. Cheung : « Polycrystalline silicon layer transfer by ion-cut », Applied Physics Letters, Vol. 82, Num. 10, March 2003.

En outre, on peut prévoir une couche intermédiaire 20 disposée entre le substrat de départ et la couche 2 sacrificielle permettant une bonne adhérence de la couche 2 sacrificielle sur le substrat 1 de départ. Cette couche 20 intermédiaire peut à la fois servir de couche d'accroche mais aussi de barrière d'arrêt à la gravure lors d'un éventuel recyclage E5 du substrat poignée consistant à retirer des résidus de la couche 2 sacrificielle présent sur le substrat 1 de départ (voir ci-dessous). Il est à noter que cette couche est particulièrement nécessaire lorsque le matériau de la couche 2 sacrificielle est identique au matériau du substrat 1.

La couche 2 sacrificielle recouvre le substrat 1 de départ. Cette couche 2 sacrificielle peut être recouverte d'une couche 21 additionnelle facilitant ultérieurement l'assemblage du substrat poignée avec le substrat 3 à manipuler. On peut ainsi prévoir de former cette couche 21 additionnelle qui se présente comme une couche superficielle de collage en oxyde. Que cette couche soit présente ou pas, il est important que la surface exposée du substrat poignée soit compatible avec l'étape ultérieure d'assemblage E2. Ainsi, s'il est envisagé d'assembler temporairement le substrat poignée avec le substrat à manipuler, par adhésion moléculaire, la rugosité de surface du substrat poignée doit être de l'ordre de 10 Angstroms RMS ou moins.

L'introduction d'espèce atomiques a pour but de former une zone 2‴ de fragilisation enterrée dans la couche 2 sacrificielle recouvrant le substrat de départ 1. Les espèces atomiques introduites peuvent être des ions d'hydrogène, d'hélium, des ions de gaz inerte ou voire des ions de fluor ou de bore, seule ou en combinaison. L'hydrogène et l'hélium sont particulièrement avantageux, car leur implantation est très courante.

Ainsi, le substrat poignée est susceptible de se séparer au niveau de la zone de fragilisation 2‴ quand il reçoit de l'énergie au niveau de cette zone (par exemple par application de chaleur et/ou d'une contrainte mécanique).

Les paramètres de l'introduction d'espèces atomiques, et en particulier la dose d'espèces introduites, peuvent être ajustés de manière à prévenir une cassure ou une séparation du substrat poignée le long de la zone de fragilisation au cours de l'assemblage du substrat poignée au substrat 3 à manipuler ou au cours des traitements sur le substrat 3, en particulier si ceux-ci comprenne une étape de traitement thermique.

Ceci permet de détacher le substrat poignée du substrat 3 à manipuler au cours de stades ultérieurs du traitement, comme cela sera décrit par la suite.

La profondeur à laquelle les espèces sont introduites dans le substrat poignée de sorte à réaliser la zone de fragilisation est principalement fonction de l'énergie avec laquelle les espèces sont introduites dans le substrat poignée. Dans la mesure où les espèces introduites sont bien essentiellement localisées dans la couche sacrificielle, la position exacte de la zone fragilisée n'est pas critique. À titre d'exemple non limitatif, les espèces atomiques peuvent être introduites dans la couche 2 sacrificielle à une profondeur comprise entre 50nm et plusieurs microns.

L'introduction d'espèces atomiques peut consister à exposer une surface du substrat poignée à une implantation d'espèces atomiques, à une dose comprise entre 10¹⁵ ions/cm² et 10¹⁷ ions/cm² et à une énergie comprise entre 5 KeV et 500 KeV.

De manière alternative, l'introduction d'espèces atomiques peut consister en une diffusion d'espèces atomiques dans le substrat poignée, c'est-à-dire une mise en contact de la surface du substrat poignée avec une espèce chimique qui va pénétrer à l'intérieur par diffusion chimique. Cela peut être réalisé par plasma.

Cette introduction peut également être réalisée lors de la formation de la couche 2 sacrificielle, par exemple en incorporant une quantité importante d'hydrogène dans la couche lors de son dépôt.

Il est à noter que contrairement au technique connue de transfert de couche fondée sur l'implantation, il n'est pas nécessaire dans le cadre de cette invention de localiser avec précision les espèces implantés pour délimiter une couche à transférer. Il est en effet suffisant d'incorporer suffisamment d'espèces dans la couche pour permettre la formation sous l'effet d'un traitement thermique de défauts tels que des lacunes ou des platelets qui permettront ultérieurement le détachement du substrat 1 de départ. La densité d'H et/ou d'He dans la couche 2 sacrificielle est comprise entre 10¹⁶ at/cm^{^3} à 10²⁰ at/cm³. Dans la couche 2 sacrificielle de polysilicium cette densité est de l'ordre de 10¹⁸ at/cm³.

En outre, quel que soit le type d'introduction des espèces atomiques on peut combiner l'introduction d'espèces avec la mise en œuvre d'un confinement lors duquel :
- avant l'introduction d'espèces, on crée d'une couche de confinement dans le substrat poignée
- après l'introduction d'espèces, on expose le substrat poignée à une température d'au moins 100°C en vue de favoriser la migration des espèces introduites vers la couche de confinement.

Comme déjà mentionné, dans une étape E2 on procède à l'assemblage du substrat poignée 1, 2 avec un substrat 3 à manipuler.

Cette étape d'assemblage E2 permet de fournir un support mécanique au substrat 3 à manipuler.

De manière avantageuse, le matériau du substrat 1 de départ constituant le substrat poignée peut être choisi de manière à avoir un coefficient de dilatation thermique proche du coefficient de dilatation thermique du substrat à manipuler. De préférence, on a |CTE1-CTE2|/CTE1<50% avec CTE1 le coefficient de dilatation thermique du substrat de départ et CTE2, le coefficient de dilatation thermique du substrat à manipuler.

Toujours de manière avantageuse, le substrat 1 de départ peut être constitué de silicium ou de tout autre matériau disponible sous forme de substrat compatible avec des traitements réalisés sur le substrat 3 à manipuler.

Ainsi, ce substrat 1 de départ doit pouvoir supporter des traitements thermiques de quelques centaines de degrés, comme par exemple jusque 500°C, résistant aux efforts mécaniques et chimiquement inerte afin de résister au traitement de type polissage mécano-chimique (CMP) ou meulage, être suffisamment souple pour pouvoir se déformer lors d'une étape de collage moléculaire. A ce titre on pourra choisir comme substrat 1 de départ, un substrat cristallin (silicium, SiC, Quartz, saphir), un substrat amorphe ou partiellement cristallin (Poly SiC, Verre , vitrocéramique), une céramique (Nitrure d'aluminium ou de silicium, mullite, alumine) ou un métal (tungstène, molybdène).

L'étape E2 d'assemblage peut consister à coller le substrat poignée 1, 2 sur le substrat 3 à manipuler.

C'est la couche 2" qui est alors en contact avec le substrat 3 à manipuler. De manière préférentielle, il s'agit d'un collage moléculaire qui ne nécessite donc pas de colle ou d'autre forme de couche adhésive, dont on a rappelé les limitations en introduction.

Une fois assemblé avec le substrat 1 qui le supporte, le substrat 3 peut subir un ou plusieurs traitement(s). Par exemple, dans le cas d'un report de circuits, le substrat 3 à manipuler est aminci en face arrière et assemblé E2' par exemple par collage sur un substrat 4 receveur final.

Dans ce cas, le matériau du substrat 1 de départ peut être choisi de manière à avoir un coefficient de dilatation thermique proche du coefficient de dilatation thermique du substrat 4 receveur final. De préférence, on a |CTE1-CTE3|/CTE1<50% avec CTE1 le coefficient de dilatation thermique du substrat de départ et CTE3, le coefficient de dilatation thermique du substrat receveur final.

Ensuite, dans une étape quatrième étape, on procède au détachement E4 du substrat poignée au niveau de la couche 2 sacrificielle et en particulier au niveau de la zone de fragilisation 2‴ dans le cas où la fragilisation a été réalisée par introduction d'espèces atomiques

De manière alternative ou complémentaire, avant cette étape de détachement on peut mettre en œuvre une étape consistant à assembler E30 le substrat 3 à manipuler et la couche 2" sur un substrat 4 receveur.

L'étape E3 de détachement consiste notamment en un apport d'énergie par recuit à une température d'au moins 200°C. Ce traitement thermique peut être complété par l'application d'effort mécanique au niveau de la zone fragilisée afin de réaliser ce détachement.

Ainsi, dans le cas où l'étape d'assemblage E30 est mise en œuvre le substrat poignée permet de disposer le substrat 3 à manipuler sur le substrat 4 receveur sans endommager le substrat 3 à manipuler.

La partie restante du substrat poignée est facilement recyclée par gravure sélective des résidus de la couche sacrificielle 2'.

A cette fin on met en œuvre une étape de retrait E5 des résidus de la couche 2 sacrificielle sur le substrat 1 de départ.

Le recyclage de la partie restante du substrat poignée ne consomme pas d'épaisseur de matériau dans le substrat poignée puisque ce sont les résidus de la couche 2 qui sont consommés.

Ceci permet de réaliser des économies de substrat par rapport aux procédés connus qui impliquent le transfert d'une partie d'un substrat de silicium et son recyclage, en consommant une partie de l'épaisseur de ce substrat.

A l'issu du procédé ci-dessus décrit on obtient une structure semi-conductrice composée éventuellement du substrat 4 receveur, du substrat 3 à manipuler et d'éventuels résidus de la couche 2' provenant de la couche sacrificielle du substrat poignée. Ces résidus seront éliminés par exemple par traitement chimique au cours de l'étape de retrait E5 des résidus de la couche 2 sacrificielle présents sur la structure semi-conductrice.

Enfin, le procédé de fabrication peut comprendre une étape de recyclage du substrat poignée consistant notamment à un lissage de la surface libre ou à une suppression de la couche 2".

Un tel lissage ou une suppression peut être mis en œuvre par un processus de rectification, un processus de gravure humide ou un processus de polissage mécano-chimique.

Dans le cas où une couche intermédiaire 20 est disposée entre le substrat de départ 1 et la couche 2 sacrificielle, la couche intermédiaire 20 peut servir de couche d'arrêt. En revanche, dans le cas où cette couche intermédiaire n'est pas présente, c'est le substrat de départ 1 qui sert de couche d'arrêt.

## Revendications

1. Procédé de fabrication d'une structure semi-conductrice, comprenant les étapes suivantes :
- fournir (E1) un substrat poignée (1, 2) comprenant un substrat de départ (1) et une couche (2) sacrificielle fragilisée recouvrant le substrat (1) de départ ;
- assemblage (E2) du substrat poignée (1, 2) avec un substrat (3) à manipuler ;
- détachement (E4) du substrat poignée au niveau de la couche (2) sacrificielle pour former la structure semi-conductrice ;
- retrait (E5) des résidus (2') de la couche (2) sacrificielle présents sur le substrat (1) de départ par gravure sélective de ladite couche sacrificielle par rapport au substrat poignée,
- formation d'une nouvelle couche (2) sacrificielle fragilisée sur le substrat de départ (1) après ledit retrait (E5) des résidus pour former un nouveau substrat poignée, et
- répétition des étapes d'assemblage (E2) du nouveau substrat poignée avec un substrat à manipuler, de détachement (E4) dudit nouveau substrat poignée au niveau de la nouvelle couche (2) sacrificielle pour former une nouvelle structure semi-conductrice, et de retrait (E5) des résidus de la nouvelle couche sacrificielle présents sur le substrat de départ par gravure sélective de ladite nouvelle couche sacrificielle par rapport au substrat poignée,
ledit procédé étant **caractérisé en ce que** la couche (2) sacrificielle est une couche de polysilicium et **en ce que** la fragilisation de la couche sacrificielle (2) est obtenue par introduction d'espèces atomiques dans ladite couche (2) sacrificielle.

2. Procédé selon la revendication 1 dans lequel le substrat (1) de départ présente un coefficient de dilatation thermique CTE1 et le substrat (3) à manipuler présente un coefficient de dilatation thermique CTE2 tel que |CTE1-CTE2|/CTE1<50%.

3. Procédé selon l'une des revendications précédentes dans lequel le substrat poignée (1, 2) comporte une couche intermédiaire (20) disposée entre le substrat (1) de départ et la couche (2) sacrificielle pour favoriser l'adhésion du matériau constituant la couche (2) sacrificielle au substrat (1) de départ.

4. Procédé selon l'une des revendications précédentes dans lequel la couche (2) sacrificielle présente une zone (2‴) de fragilisation et définit une couche (2") située entre la surface du substrat (1, 2) poignée et la zone (2‴) de fragilisation.

5. Procédé selon l'une des revendications précédentes dans lequel avant l'étape de détachement (E3), le procédé comprend une étape consistant à assembler (E30) le substrat (3) à manipuler à un substrat (4) receveur.

6. Procédé selon la revendication 5, dans lequel le substrat (1) de départ est choisi de manière à présenter un coefficient de dilatation thermique CTE1 tel que |CTE1-CTE2|lCTE1<50%, où CTE2 est le coefficient de dilatation thermique du substrat receveur (4).

7. Procédé selon l'une des revendications précédentes dans lequel le substrat (3) à manipuler comporte une partie d'un circuit intégré.

8. Procédé selon l'une des revendications précédentes dans lequel l'étape de détachement consiste en un apport d'énergie par recuit à une température d'au moins 200°C.

9. Procédé selon l'une des revendications précédentes, dans lequel l'introduction d'espèces atomiques consiste à exposer une surface du substrat (1, 2) poignée à une implantation d'espèces atomiques, à une dose comprise entre 10¹⁵ ions/cm² et 10¹⁷ ions/cm² et à une énergie comprise entre 5 KeV et 500 KeV.

10. Procédé selon l'une des revendications précédentes dans lequel l'introduction d'espèces atomiques consiste en une diffusion d'espèces atomiques dans le substrat poignée consistant à une mise en contact de la surface du substrat poignée avec une espèce chimique qui va pénétrer à l'intérieur par diffusion chimique.

11. Procédé selon l'une des revendications 9 et 10 dans lequel l'introduction d'espèces atomiques implique :
- avant l'introduction des espèces atomiques, la création d'une couche de confinement dans le substrat poignée,
- après l'introduction des espèces atomiques, l'exposition du substrat poignée à une température d'au moins 200°C en vue de favoriser la migration des espèces introduites vers la couche de confinement.

12. Procédé selon l'une des revendications précédentes dans lequel l'assemblage consiste à coller le substrat poignée (1, 2) sur le substrat (3) à manipuler.

13. Procédé selon la revendication 12 dans lequel l'assemblage est réalisé par adhésion moléculaire.

14. Procédé selon l'une des revendications précédentes dans lequel le substrat (1) de départ est :
- un substrat cristallin ; ou
- un substrat amorphe ou partiellement cristallin ; ou
- une céramique ; ou
- un métal.

15. Procédé selon l'une des revendications précédentes comprenant en outre, entre les étapes d'assemblage (E2) et de détachement (E4), une étape de traitement (E3) du substrat à manipuler (3).

## Patentansprüche

1. Verfahren zur Herstellung einer Halbleiterstruktur, umfassend die folgenden Schritte:
- Bereitstellen (E1) eines Griffsubstrats (1, 2), umfassend ein Ausgangssubstrat (1) und eine geschwächte Opferschicht (2), die das Ausgangssubstrat (1) abdeckt;
- Zusammenfügen (E2) des Griffsubstrats (1, 2) mit einem handzuhabenden Substrat (3);
- Ablösen (E4) des Griffsubstrats auf der Ebene der Opferschicht (2), um die Halbleiterstruktur zu bilden;
- Entfernen (E5) von Resten (2') der Opferschicht (2), die auf dem Ausgangssubstrat (1) vorhanden sind, durch selektives Ätzen der Opferschicht in Bezug auf das Griffsubstrat,
- Bilden einer neuen geschwächten Opferschicht (2) auf dem Ausgangssubstrat (1) nach dem Entfernen (E5) von Resten, um ein neues Griffsubstrat zu bilden, und
- Wiederholen der Schritte des Zusammenfügens (E2) des neuen Griffsubstrats mit einem zu handhabenden Substrat, des Ablösens (E4) des neuen Griffsubstrats auf der Ebene der neuen Opferschicht (2), um eine neue Halbleiterstruktur zu bilden, und des Entfernens (E5) von Resten der neuen Opferschicht, die auf dem Ausgangssubstrat vorhanden sind, durch selektives Ätzen der neuen Opferschicht in Bezug auf das Griffsubstrat,
wobei das Verfahren **dadurch gekennzeichnet ist, dass** die Opferschicht (2) eine Polysiliziumschicht ist und dass die Schwächung der Opferschicht (2) durch Einbringen von atomaren Spezies in die Opferschicht (2) erreicht wird.

2. Verfahren nach Anspruch 1, wobei das Ausgangssubstrat (1) einen Wärmeausdehnungskoeffizienten CTE1 aufweist und das handzuhabende Substrat (3) einen Wärmeausdehnungskoeffizienten CTE2 aufweist, so dass |CTE1-CTE2|/CTE1<50 %.

3. Verfahren nach einem der vorhergehenden Ansprüche, wobei das Griffsubstrat (1, 2) eine Zwischenschicht (20) umfasst, die zwischen dem Ausgangssubstrat (1) und der Opferschicht (2) angeordnet ist, um die Adhäsion des Materials, das die Opferschicht (2) bildet, an dem Ausgangssubstrat (1) zu begünstigen.

4. Verfahren nach einem der vorhergehenden Ansprüche, wobei die Opferschicht (2) eine Schwächungszone (2‴) aufweist und eine Schicht (2") definiert, die sich zwischen der Oberfläche des Griffsubstrats (1, 2) und der Schwächungszone (2‴) befindet.

5. Verfahren nach einem der vorhergehenden Ansprüche, wobei das Verfahren vor dem Schritt des Ablösens (E3) einen Schritt umfasst, der in einem Zusammenfügen (E30) des handzuhabenden Substrats (3) mit einem Empfängersubstrat (4) besteht.

6. Verfahren nach Anspruch 5, wobei das Ausgangssubstrat (1) so ausgewählt ist, dass es einen Wärmeausdehnungskoeffizienten CTE1 aufweist, so dass |CTE1-CTE2|/CTE1<50 %, wobei CTE2 der Wärmeausdehnungskoeffizient des Empfängersubstrats (4) ist.

7. Verfahren nach einem der vorhergehenden Ansprüche, wobei das handzuhabende Substrat (3) einen Teil einer integrierten Schaltung umfasst.

8. Verfahren nach einem der vorhergehenden Ansprüche, wobei der Schritt des Ablösens in einer Energiezufuhr durch Tempern bei einer Temperatur von mindestens 200 °C besteht.

9. Verfahren nach einem der vorhergehenden Ansprüche, wobei das Einbringen von atomaren Spezies in einem Unterziehen einer Oberfläche des Griffsubstrats (1, 2) einem Implantieren von atomaren Spezies bei einer Dosis, die zwischen 10¹⁵ Ionen/cm² und 10¹⁷ Ionen/cm² liegt, und bei einer Energie, die zwischen 5 KeV und 500 KeV liegt, besteht.

10. Verfahren nach einem der vorhergehenden Ansprüche, wobei das Einbringen von atomaren Spezies in einem Diffundieren von atomaren Spezies in dem Griffsubstrat besteht, bestehend in einem Inkontaktbringen der Oberfläche des Griffsubstrats mit einer chemischen Spezies, die durch chemische Diffusion in das Innere eindringt.

11. Verfahren nach einem der Ansprüche 9 und 10, wobei das Einbringen von atomaren Spezies beinhaltet:
- vor dem Einbringen von atomaren Spezies das Erzeugen einer Einschränkungsschicht in dem Griffsubstrat,
- nach dem Einbringen von atomaren Spezies das Unterziehen des Griffsubstrats einer Temperatur von mindestens 200 °C zwecks des Begünstigens der Migration von eingebrachten Spezies zur Einschränkungsschicht.

12. Verfahren nach einem der vorhergehenden Ansprüche, wobei das Zusammenfügen in einem Kleben des Griffsubstrats (1, 2) auf das handzuhabende Substrat (3) besteht.

13. Verfahren nach Anspruch 12, wobei das Zusammenfügen durch molekulare Adhäsion durchgeführt wird.

14. Verfahren nach einem der vorhergehenden Ansprüche, wobei das Ausgangssubstrat (1):
- ein kristallines Substrat; oder
- ein amorphes oder teilkristallines Substrat; oder
- ein Keramikmaterial; oder
- ein Metall ist.

15. Verfahren nach einem der vorhergehenden Ansprüche, weiterhin umfassend zwischen den Schritten des Zusammenfügens (E2) und des Ablösens (E4) einen Schritt des Behandelns (E3) des handzuhabenden Substrats (3).

## Claims

1. A method for manufacturing a semiconductor structure, comprising the following steps:
- providing (E1) a handle substrate (1, 2) comprising a starting substrate (1) and a weakened sacrificial layer (2) covering the starting substrate (1);
- assembling (E2) the handle substrate (1, 2) with a substrate (3) to be handled;
- detaching (E4) the handle substrate at the sacrificial layer (2) to form the semiconductor structure;
- removing (E5) the residues (2') from the sacrificial layer (2) present on the starting substrate (1) by selective etching of said sacrificial layer relative to the handle substrate,
- forming a new weakened sacrificial layer (2) on the starting substrate (1) after said removal (E5) of the residues to form a new handle substrate, and
- repeating the steps of assembling (E2) the new handle substrate with a substrate to be handled, of detaching (E4) said new handle substrate at the new sacrificial layer (2) to form a new semiconductor structure, and of removing (E5) the residues from the new sacrificial layer present on the starting substrate by selective etching of said new sacrificial layer relative to the handle substrate,
said method being **characterized in that** the sacrificial layer (2) is a polysilicon layer and **in that** the weakening of the sacrificial layer (2) is obtained by introducing atomic species into said sacrificial layer (2).

2. The method according to claim 1, wherein the starting substrate (1) has a coefficient of thermal expansion CTE1 and the substrate (3) to be handled has a coefficient of thermal expansion CTE2 such that |CTE1-CTE2|/CTE1<50%.

3. The method according to one of the preceding claims, wherein the handle substrate (1, 2) includes an intermediate layer (20) disposed between the starting substrate (1) and the sacrificial layer (2) to promote adhesion of the material constituting the sacrificial layer (2) to the starting substrate (1).

4. The method according to one of the preceding claims, wherein the sacrificial layer (2) has a weakened zone (2‴) and defines a layer (2") located between the surface of the handle substrate (1, 2) and the weakened zone (2‴).

5. The method according to one of the preceding claims, wherein before the detachment step (E3), the method comprises a step of assembling (E30) the substrate (3) to be handled to a receiving substrate (4).

6. The method according to claim 5, wherein the starting substrate (1) is selected so as to have a coefficient of thermal expansion CTE1 such that |CTE1-CTE2|/CTE1<50%, where CTE2 is the coefficient of thermal expansion of the receiving substrate (4).

7. The method according to one of the preceding claims, wherein the substrate (3) to be handled includes a part of an integrated circuit.

8. The method according to one of the preceding claims, wherein the detachment step consists in supplying energy by annealing at a temperature of at least 200°C.

9. The method according to one of the preceding claims, wherein the introduction of atomic species consists in exposing a surface of the handle substrate (1, 2) to an implantation of atomic species, at a dose comprised between 10¹⁵ ions/cm² and 10¹⁷ ions/cm² and at an energy comprised between 5 KeV and 500 KeV.

10. The method according to one of the preceding claims, wherein the introduction of atomic species consists in diffusing atomic species into the handle substrate consisting in contacting the surface of the handle substrate with a chemical species which will penetrate inside by chemical diffusion.

11. The method according to one of claims 9 and 10, wherein the introduction of atomic species involves:
- before the introduction of atomic species, the creation of a confinement layer in the handle substrate,
- after the introduction of the atomic species, the exposure of the handle substrate to a temperature of at least 200°C in order to promote the migration of the introduced species towards the confinement layer.

12. The method according to one of the preceding claims, wherein the assembly consists in bonding the handle substrate (1, 2) to the substrate (3) to be handled.

13. The method according to claim 12 wherein the assembly is carried out by molecular adhesion.

14. The method according to one of the preceding claims, wherein the starting substrate (1) is:
- a crystalline substrate; or
- an amorphous or partially crystalline substrate; or
- a ceramic; or
- a metal.

15. The method according to one of the preceding claims further comprising, between the assembly (E2) and detachment (E4) steps, a step of treatment (E3) of the substrate to be handled (3).
